# EUROPEAN PATENT APPLICATION

(11) **EP 4 273 895 A1**
(43) Date of publication of application: **08.11.2023**
(21) Application number: 23167296.5
(22) Date of filing: 11.04.2023
(51) Int. Cl.: H01F 27/28, H01F 37/00, H01F 27/06

(54) **EMI FILTER SYSTEM**

(30) Priority: 04.05.2022 US 202263338279 P; 06.12.2022 CN 202211558341
(71) Applicant: Delta Electronics, Inc., Taoyuan City 33370 (TW)
(72) Inventor: Wu, Chun-Wei, 32063 Taoyuan City (TW); Yeh, Chia-Hao, 32063 Taoyuan City (TW); Lin, Hung-Chuan, 32063 Taoyuan City (TW)
(74) Representative: Uexküll & Stolberg

(57) **Abstract**

An EMI filter system (4) includes a circuit board (3) and a choke (2). The circuit board (3) includes at least three capacitors (31). The choke (2) mounts on the circuit board (3) and includes a non-circular magnetic core (21) and at least three windings (22). The at least three windings (22) are wound on the non-circular magnetic core (21). The at least three capacitors (31) are disposed adjacent to the choke (2), and first outlet ends (22a) of the at least three windings (22) are respectively connected to the corresponding at least three capacitors (31).

## Description

### FIELD OF THE INVENTION

The present invention relates to an EMI filter system, and more particularly to an EMI filter system applicable for a three-phase grid and including a choke with a non-circular magnetic core.

### BACKGROUND OF THE INVENTION

With increasing development of science and technology, a variety of electrical appliances are frequently used. As known, power supply is necessary for normal operation of the electrical appliance. However, when AC power is supplied to the electrical appliance, the current provided by the AC power usually contains noise because of the power supply or the operations of some components (e.g. high-frequency transformers, stray capacitors or parasitic capacitors). The noise is also referred as electromagnetic Interference (EMI).

When an AC power is used, the generated noise includes differential mode noise or common mode noise may occur. An electromagnetic interference filter (also referred as an EMI filter) is used as a first defense line for protecting the power source from electromagnetic radiation. Generally, the EMI includes a choke and a capacitor. The choke is an inducting element for inhibiting noise generation. Moreover, the choke includes at least one winding coil, a magnetic core assembly, and a bobbin for winding the winding coil.

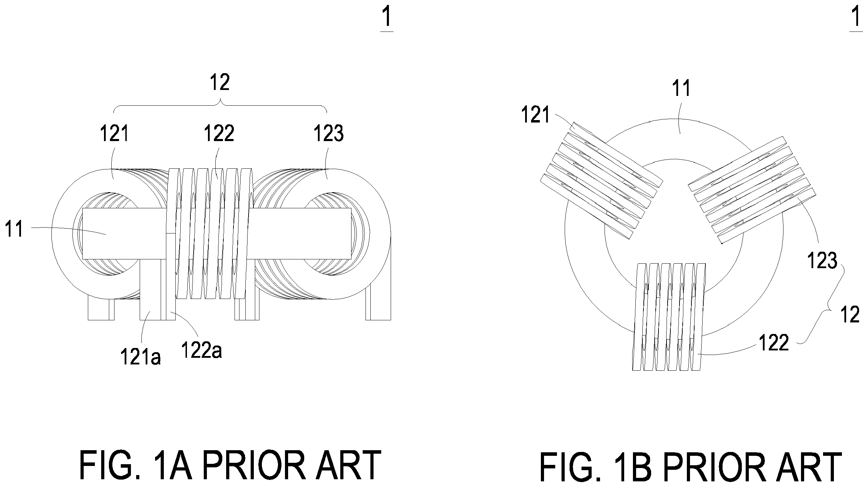

FIGS. 1A and 1B are schematic views showing a conventional EMI choke taken along different viewpoints. As shown in FIGS. 1A and 1B, the conventional choke 1 usually includes a circle-shape magnetic core 11 with a hollow portion and a plurality of coils 12. The coils 12 are wound on the circle-shape magnetic core 11.

Traditionally, in order to increase the inductance of the conventional choke 1, it is necessary to increase the number of turns of the coils 12. However, as shown in FIG. 1B, the inner diameter of the circle-shape magnetic core 11 is fixed, that is, the space of the hollow portion of the circle-shape magnetic core 11 is limited. Namely, in the prior art, the circle-shape magnetic core 11 can be provided for the only three coils 121, 122, 133 wound thereof, and the number of turns can't be increased further. In other words, even if it is desired to increase the number of the coils 12 or the number of turns to increase the inductance, it will be limited by the inner diameter of the circle-shape magnetic core 11, and it is difficult to further increase the number and number of turns of the coils 12.

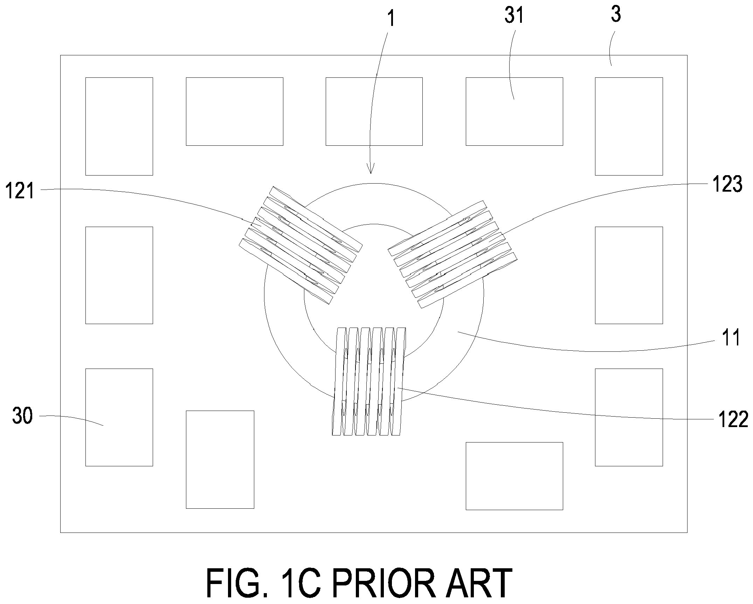

In addition, in case that the space of the hollow portion of the circle-shape magnetic core 11 is small and larger current flows through the coils 12, the conventional choke 1 may be subjected to a safety distance issue between the coils 12 and the layout of the printed circuit board 3 (as shown in FIG. 1C) is difficult to be designed. For example, as shown in FIG. 1A, since the pins 121a, 122a of the coils 121, 122 wound around the circle-shape magnetic core 11 are too close to each other. When they are laid on the circuit board 3 as shown in FIG. 1C, the safety distance between the pins 121a and 122a is insufficient, so that the layout of the conventional circuit board 3 is difficult to be designed. Moreover, as shown in FIG. 1C, since the three coils 12 are wound on the circle-shape magnetic core 11 in a diagonal manner, the outlet positions of the pins 121a, 122a on the circuit board 3 are deflected as an oblique angle (i.e., not a horizontal or vertical position), so that the arrangement and the number of the electronic components 30 and the capacitor 31 of the conventional circuit board 3 are affected, resulting in design difficulties.

Furthermore, in some other prior arts, in order to solve the problems of the inductance and the safety distance of the conventional choke 1, it is necessary to adopt a larger-sized circle-shape magnetic core 11 to increase the inductance and meet the safety distance requirements. In this way, the conventional choke 1 will has large size, which results in a large device volume and the electronic device is unable to be miniaturized.

Therefore, there is a need of providing an EMI filter system in order to the overcome the above issues.

### SUMMARY OF THE INVENTION

It is an object of the present invention to provide an EMI filter system, which is applicable to a power conversion device for the three-phase grid. The EMI filter system includes a choke with a non-circular magnetic core. Through the non-circular magnetic core has a larger inner diameter, the distance between the windings can be pulled further apart, the safety distance between the windings is sufficient and the layout problem of the conventional printed circuit board is also solved.

It is another object of the present invention to provide an EMI filter system, which includes a choke with a non-circular magnetic core. Through the shape of the non-circular magnetic core of the choke and the winding position of at least three windings and their arrangement in series or parallel, the number and position of the capacitors disposed on the circuit board can be flexibly adjusted. Consequently, the EMI filter system can achieve the efficacy of increasing the space utilization rate of the circuit board, reducing the overall device volume, increasing inductance, or performing current shunting and reducing loss.

In accordance with an aspect of the present invention, there is provided an EMI filter system. The EMI filter system includes a circuit board and a choke. The circuit board includes at least three capacitors. The choke mounts on the circuit board and includes a non-circular magnetic core and at least three windings. The at least three windings are wound on the non-circular magnetic core. The at least three capacitors are disposed adjacent to the choke, and first outlet ends of the at least three windings are respectively connected to the corresponding at least three capacitors.

In an embodiment, the non-circular magnetic core further comprises a hollow portion, when the at least three windings are wound on the non-circular magnetic core, a portion of each winding passes through the hollow portion and is wound on the non-circular magnetic core.

In an embodiment, the non-circular magnetic core is an oval ring-shape magnetic core.

In an embodiment, the non-circular magnetic core comprises an oval ring-shape main body and a U-shape extension part.

In an embodiment, when the choke is mounted on the circuit board, the at least three capacitors are disposed on a same side of the choke.

In an embodiment, when the choke is mounted on the circuit board, the at least three capacitors are disposed on two opposite sides of the choke.

In an embodiment, the at least three windings are arranged in series, in parallel, or in series and parallel.

In an embodiment, the EMI filter system further comprises an additional circuit board, and the additional circuit board comprises at least one capacitor for corresponding connecting to at least one second outlet end of the at least three windings.

In accordance with an aspect of the present invention, there is provided an EMI filter system. The EMI filter system comprises a circuit board, an additional circuit board and a choke. The circuit board includes at least three capacitors. The additional circuit board comprising at least one capacitor. The choke is sandwiched between the circuit board and the additional circuit board, and includes a non-circular magnetic core and at least three windings. The at least three windings are wound on the non-circular magnetic core. The at least three capacitors of the circuit board and the at least one capacitor of the additional circuit board are disposed adjacent to the choke. First outlet ends of the at least three windings are respectively connected to the corresponding at least three capacitors of the circuit board, and at least one second outlet end of the at least three windings is connected to the at least one capacitor of the additional circuit board.

In an embodiment, when the choke is sandwiched between the circuit board and the additional circuit board, a first side faces the circuit board, and a second side faces the additional circuit board.

The above contents of the present invention will become more readily apparent to those ordinarily skilled in the art after reviewing the following detailed description and accompanying drawings, in which:

### BRIEF DESCRIPTION OF THE DRAWINGS

FIGS. 1A and 1B are schematic views showing a conventional EMI choke taken along different viewpoints;
FIG. 1C is a schematic view showing the conventional EMI choke of FIGS. 1A and 1B arranging on a conventional circuit board;
FIG. 2 is a schematic view showing an EMI filter system according to a first embodiment of the present invention;
FIG 3 is a schematic view showing a choke of the EMI filter system of FIG 2;
FIG 4A is a schematic view showing the choke of the EMI filter system according to a second embodiment of the present invention;
FIG 4B is a schematic view showing the choke of the EMI filter system according to a third embodiment of the present invention;
FIG 5A is a schematic lateral view showing the EMI filter system according to a fourth embodiment of the present invention;
FIG 5B is a schematic top view the EMI filter system of FIG 5A;
FIG 6 is a schematic top view showing the EMI filter system according to a fifth embodiment of the present invention;
FIG 7A is a schematic lateral view showing the EMI filter system according to a sixth embodiment of the present invention;
FIG 7B is a schematic top view showing the EMI filter system according to a fifth embodiment of FIG 7A; and
FIG 8 is a schematic stereo view showing the EMI filter system according to a seventh embodiment of the present invention.

### DETAILED DESCRIPTION OF THE PREFERRED EMBODIMENT

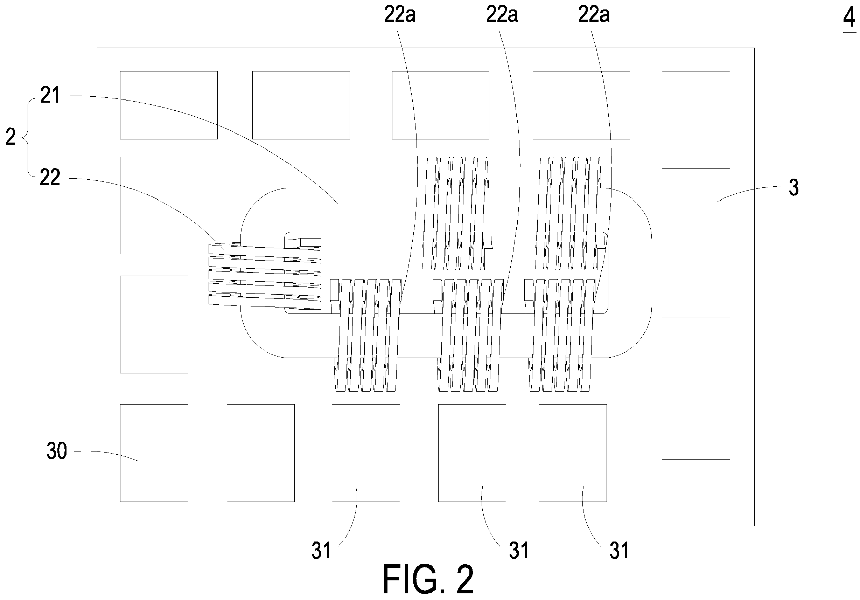

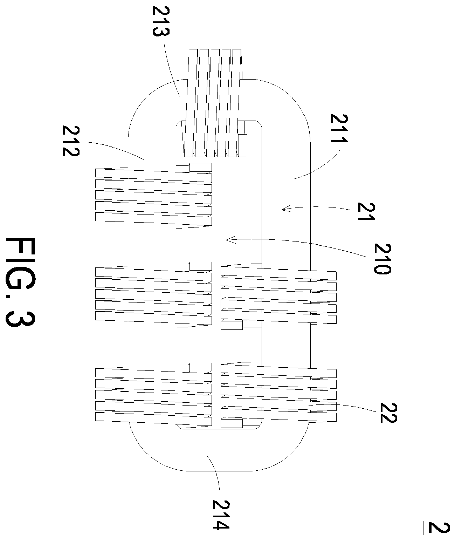

Please refer to FIGS. 2 and 3. FIG. 2 is a schematic view showing an EMI filter system according to a first embodiment of the present invention. FIG. 3 is a schematic view showing a choke of the EMI filter system of FIG. 2. In the embodiment of the present invention, the EMI filter system 4 is applicable to a power conversion device for the three-phase grid, but not limited to. The EMI filter system 4 includes a circuit board 3 and a choke 2. The choke 2 is a noise filter or an inductor employed in a circuit board assembly of an electric device, such as a switch power supply, for suppressing electromagnetic noise. The circuit board 3 includes a plurality of electronic components 30, wherein includes at least three capacitors 31. The choke 2 is mounted on the circuit board 3, and includes a non-circular magnetic core 21 and at least three windings 22. The non-circular magnetic core 21 has a hollow portion 210, and a portion of each winding 22 passes through the hollow portion 210 and is wound on the non-circular magnetic core 21. The non-circular magnetic core 21 can be in any shape except circle shape. Preferably but not exclusively, the non-circular magnetic core 21 is a magnetic core in an oval ring shape, but not limited thereto. When the choke 2 is mounted on the circuit board 3, the at least three capacitors 31 are disposed adjacent to the choke 2, and are disposed on the same side of the choke 2, and the first outlet ends 22a of the at least three windings 22 are respectively connected to the corresponding at least three capacitors 31.

As shown in FIG. 3, in this embodiment, the non-circular magnetic core 21 of the choke 2 is an oval ring-shape magnetic core and includes a first magnetic portion 211, a second portion 212, a third portion 213 and a fourth magnetic portion 214. The first magnetic portion 211 and the second magnetic portion 212 are opposed to each other and arranged in parallel. The third magnetic portion 213 and the fourth magnetic portion 214 are opposed to each other and arranged in parallel. The first magnetic portion 211 and the second magnetic portion 212 are connected with the third magnetic portion 213 and the fourth magnetic portion 214, and the third magnetic portion 213 and the fourth magnetic portion 214 are disposed between the first magnetic portion 211 and the second magnetic portion 212. The lengths of the first magnetic portion 211 and the second magnetic portion 212 are greater than the lengths of the third magnetic portion 213 and the fourth magnetic portion 214, respectively. The four interconnections among the first magnetic part 211, the second magnetic part 212, the third magnetic part 213 and the fourth magnetic part 214 are formed with four corners, which are rounded, but not limited thereto. In this embodiment, the at least three windings 22 are cooper foil coils. Preferably but not exclusively, the number of the at least three windings 22 is six, but the material and the number of the windings 22 are not limited to the above embodiment and are adjustable according to the practical requirements. In the embodiment, the six windings 22 are wound on 3the non-circular magnetic core 21 and spaced apart with each other, and a portion of each of the windings 22 passes through the hollow portion 210 of the non-circular magnetic core 21. In some embodiment, two of the six windings 22 are wound on the first magnetic portion 211, three of the six windings 22 are wound on the second magnetic portion 212, and the final one winding 22 is wound on the third magnetic portion 213. Accordingly, the outlet positions of the windings 22 are generally arranged regularly, such as horizontally or vertically. It is noted that the location of the windings 22 is not limited to the above embodiment and are adjustable according to the practical requirements.

Please refer to FIGS. 1C and 2 in the same time. In the embodiment, since the non-circular magnetic core 21 is an oval ring-shape magnetic core, the hollow portion 210 disposed in the center has a large space, so that the winding distance of the windings 22 can be adjustable according to the practical requirements. Compared with the conventional circuit board as shown in FIG. 1C, it is cleared that the winding distance between the plurality of windings 22 is relatively large, so that the problem of difficult layout of the conventional printed circuit board 1 can be solved. In addition, in the embodiment, there are six windings 22 wound on the non-circular magnetic core 21, when the six windings 22 are arranged in series in pairs, the number of turns is obviously more than the number of turns of each conventional coil 12. In other words, if the choke 2 with larger inductance is desired, the inductance can be increased through the series connection of the plurality of windings 22. In some other embodiments, if it is desired to disperse the current to reduce the loss when the current is too large, the plurality of windings 22 can be connected in parallel to shunt the current. Consequently, the inductance of the choke 2 remains unchanged, but the current can be shunted to reduce loss. Moreover, if the EMI filter system 4 of the present invention is compared with the prior art, as shown in FIG. 2, since the non-circular magnetic core 21 of the present invention is an oval ring-shape magnetic core, when the six windings 22 wound on the oval ring-shape magnetic core, the outlet positions of the first outlet ends 22a are generally arranged regularly, such as horizontally or vertically. Consequently, when the choke 2 is mounted on the circuit board 3, there is sufficient space around the outlet positions of the first outlet ends 22a for the installation of more electronic components. Take this embodiment for example, there are 14 electronic components can be installed on the circuit board 3, and there is little vacant space on the circuit board 3. As shown in FIG. 1C, since the conventional choke 1 has a circle-shape magnetic core 11, and its three coils 12 are wound on the circle-shape magnetic core 11 in a diagonal manner, the outlet positions of the three coils 12 are deflected as an oblique angle. In other words, it is difficult to arrange electronic components around the outlet ends of the conventional coils 12 by the limitation of the shape of the circle-shape magnetic core 11and its deflected outlet positions. Accordingly, there are only 11 electronic components can be arranged on the conventional circuit board 3, and the circuit board 3 has more space that is difficult to use, so that the space utilization rate of the prior art is obviously poor. Consequently, this embodiment uses an oval ring-shape magnetic core as the non-circular magnetic core 21, and incorporates with the at least three windings 22 wound on the non-circular magnetic core 21 in a substantially horizontal or vertical manner, so that the space utilization rate of the circuit board 3 is effectively improved, the number of the electronic components of the circuit board 3 is increased, and the layout and the arrangement design of the circuit board 3 is beneficial. It is noted that the number of the electronic components of the circuit board 3 is not limited to the above embodiment and are adjustable according to the practical requirements.

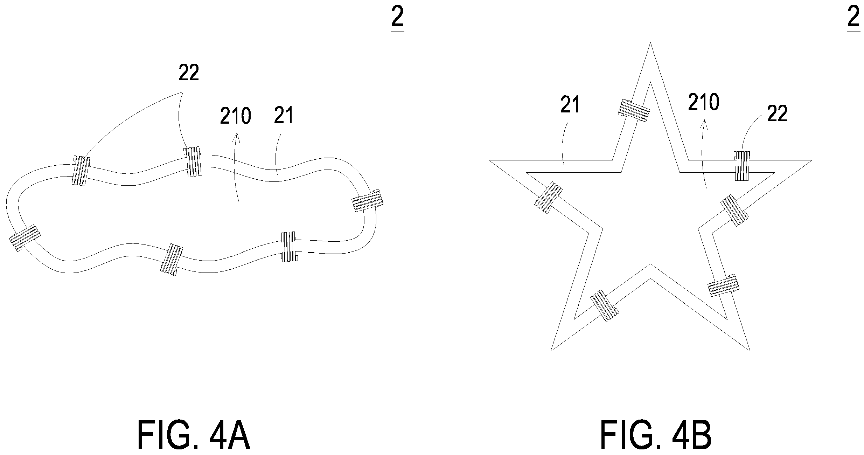

Please refer to FIGS. 4A and 4B. FIG. 4A is a schematic view showing the choke of the EMI filter system according to a second embodiment of the present invention. FIG. 4B is a schematic view showing the choke of the EMI filter system according to a third embodiment of the present invention. As shown in FIGS. 4A and 4B, it is understood that the non-circular magnetic core 21 is not limited to an oval ring-shape magnetic core, which can also be an irregular shape. In some embodiments, the non-circular magnetic core 21 is a wave ring-shape magnetic core as shown in FIG. 4A. The non-circular magnetic core 21 with wave ring shape also has a hollow portion 210, wherein the at least three windings 22 are wound on the non-circular magnetic core 21 with wave ring shape and spaced apart with each other, and a portion of each winding 22 passes through the hollow portion 210 and is wound on the non-circular magnetic core 21. In some other embodiments, the non-circular magnetic core 21 of the choke 2 is a star ring-shape magnetic core as shown in FIG. 4B, wherein the at least three windings 22 are wound on the non-circular magnetic core 21 with star ring shape and spaced apart with each other, and a portion of each winding 22 passes through the hollow portion 210 and is wound on the non-circular magnetic core 21. Consequently, the non-circular magnetic core 21 of the choke 2 of the present invention can be any shape other than circular, it can have various types, and is not limited to the above embodiment and can be changed according to the practical requirements.

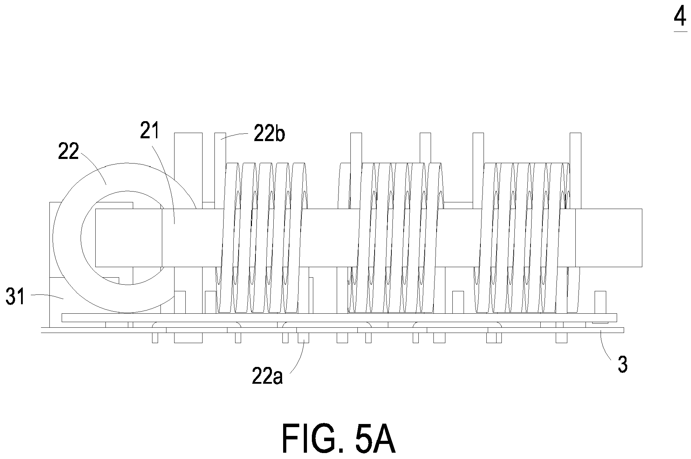

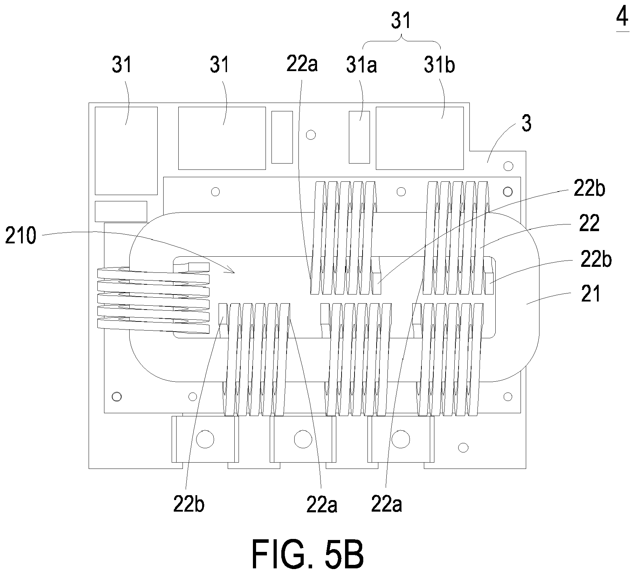

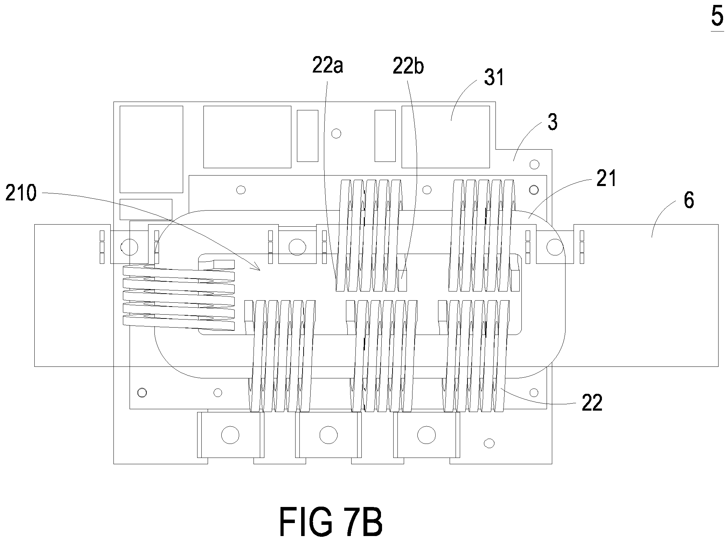

Please refer to FIGS. 5A and 5B. FIG. 5A is a schematic lateral view showing the EMI filter system according to a fourth embodiment of the present invention. FIG. 5B is a schematic top view the EMI filter system of FIG. 5A. In the embodiment, the EMI filter system 4 also includes a circuit board 3 and a choke 2. The choke 2 is mounted on the circuit board 3, and includes a non-circular magnetic core 21 and at least three windings 22. The at least three windings 22 are wound on the non-circular magnetic core 21 and spaced apart with each other, and a portion of each winding 22 passes through the hollow portion 210 and is wound on the non-circular magnetic core 21. In this embodiment, the number of turns of any two windings 22 is the same, so that the windings 22 can be arranged in series or in parallel according to different situations, so as to increase the inductance or shunt the current. In some other embodiments, it can also be arranged in series and parallel, which is not limited to the above embodiment and can be changed according to the practical requirements. As shown in FIG. 5B, there are at least three capacitors 31 disposed on the circuit board 3, take this embodiment as an example, the number of the at least three capacitors 31 is three. Preferably but not exclusively, the three capacitors 31 are disposed adjacent to the choke 2, and are disposed on the same side of the choke 2, and the first outlet ends 22a of the at least three windings 22 are respectively connected to the corresponding three capacitors 31, and the second outlet ends 22b of the at least three windings 22 may be connected to another remote circuit board (not shown) by wirings, so as to connect to the capacitors (not shown) arranged on the remote circuit board. In other words, in this embodiment, it mainly shows that one side of the choke 2 can be directly electrically connected to at least three capacitors 31 on the circuit board 3, and the other side is electrically connected to the remote circuit board (not shown) through wiring. While in other embodiments, there may be four, five, six or more capacitors 31 disposed on the circuit board 3, and the positions can be disposed on the two opposite sides, or any two sides of the choke 2. The number and the positions of the at least three capacitors 31 can be changed according to the shape of the non-circular magnetic core 21 and the outlet positions of the at least three windings 22, but not limited thereto. Moreover, as shown in FIG. 7B, in this embodiment, the at least three capacitors 31 includes Y capacitors 31a and X capacitors 31b, but not limited to, and the first outlet ends 22a of the at least three or more windings 22 are correspondingly connected to the Y capacitor 31a and the X capacitor 31b at the same time. In some other embodiments, the choke 2 can be a differential mode inductor or a common mode inductor, and which can cooperate with the required Y capacitor 3 1a and X capacitor 31b, and the number and the positions are not limited to the above embodiment.

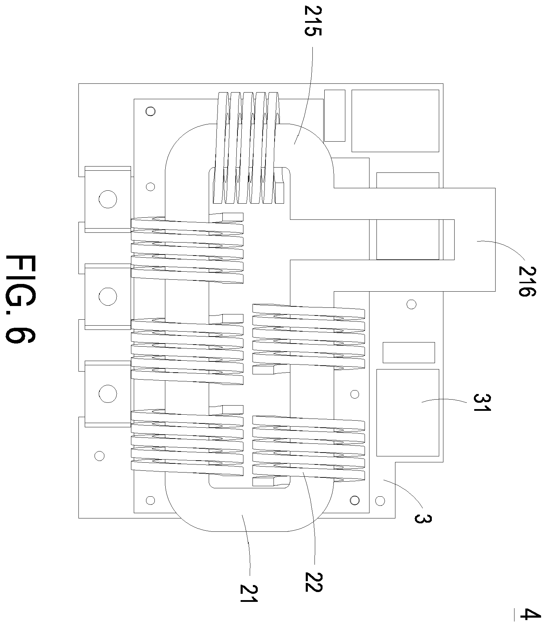

Please refer to FIG. 6. FIG. 6 is a schematic top view showing the EMI filter system according to a fifth embodiment of the present invention. The structures and the arrangements of the choke 2 and the circuit board 3 of the EMI filter system 4 of this embodiment are similar to above embodiments, and are not redundantly described hereinafter. While in this embodiment, the shape of the non-circular magnetic core 21 is a combination of an oval ring-shape magnetic core and a U-shape magnetic core. In other words, the non-circular magnetic core 21 includes an oval ring-shape main body 215 with a notch, a portion of the oval ring-shape main body 215 is protruded outwardly to form a U-shape extension part 216. Two ends of the U-shape extension part 216 are connected to the two ends of the oval ring-shape main body 215 through the notch. In the embodiment, the at least three windings 22 are wound on the oval ring-shape main body 215 of the non-circular magnetic core 21, and spaced apart with each other, instead of being wound on the U-shape extension part 216. In some other embodiments, the at least three windings 22 could be wound on the U-shape extension part 216 to match the layout and the positions of the capacitors 31 of the circuit board 3. Therefore, the shape of the non-circular magnetic core 21 and the winding positions of the at least three windings 22 can be changed according to the layout of the circuit board 3.

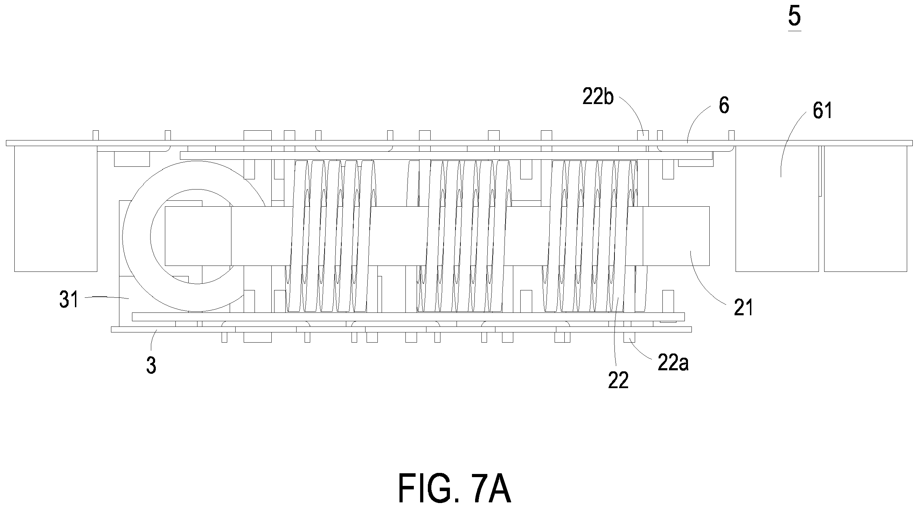

Please refer to FIGS. 7A and 7B. FIG. 7A is a schematic lateral view showing the EMI filter system according to a sixth embodiment of the present invention. FIG. 7B is a schematic top view showing the EMI filter system according to a fifth embodiment of FIG. 7A. As shown in FIGS. 7A and 7B, the EMI filter system 5 of this embodiment not only includes the choke 2 and the circuit board 3, but also includes an additional circuit board 6. As shown in FIGS. 7A and 7B, the choke 2 of this embodiment is disposed between the circuit board 3 and the additional circuit board 6 to form a sandwich type EMI filter system 5. In this embodiment, a first side (i.e., the bottom side) of the choke 2 faces and is disposed on the circuit board 3, and a second side (i.e., the top side) faces and is disposed on the additional circuit board 6, so as to sandwich the choke 2 between the circuit board 3 and the additional circuit board 6. As shown in FIG. 7B, the choke 2 also includes a non-circular magnetic core 21 and at least three windings 22, and the number of the at least three windings 22 is six. Namely, the six windings 22 are wound on the non-circular magnetic core 21 and spaced apart with each other, and a portion of each of the windings 22 passes through the hollow portion 210 of the non-circular magnetic core 21. Similar to the above embodiments, there are at least three capacitors 31 disposed on the circuit board 3, wherein in the embodiment, the number of the capacitors 31 is three, and the three capacitors 31 are disposed adjacent to the choke 2, and are disposed on the same side of the choke 2, and the first outlet ends 22a of the at least three windings 22 are respectively connected to the corresponding three capacitors 31. Similarly, there is at least one capacitor 61 disposed on the additional circuit board 6. Preferably but not exclusively, the number of the capacitor 61 of the embodiment is also three. As shown in FIG. 7A, the three capacitors 61 are correspondingly disposed on the two opposite sides of the choke 2, that is, two capacitors 61 are arranged on one side of the choke 2, and another capacitor 61 is arranged on the other side of the choke 2, so as to sandwich the choke 2 between the three capacitors 61. Moreover, the three capacitors 61 are correspondingly connected to the second outlet end 22b of the six windings 22. In the embodiment, since the capacitors 31 of the circuit board 3 and the capacitors 61 of the additional circuit board 6 are disposed adjacent to the choke 2, the electromagnetic interference can be effectively suppressed. In some embodiments, the capacitors 31 and the capacitors 61 are disposed adjacent to the choke 2 in a locking manner, but not limited thereto. In addition, by the sandwich arrangement manner of this embodiment, the disposed positions and the number of electronic components of the circuit board 3 and the additional circuit board 6 can be more flexibly regulated. For example, when the space of the circuit board 3 is not enough to place six capacitors 31, perhaps only three capacitors 31 or four capacitors 31 can be placed, and by setting the additional circuit board 6, the other two capacitors 61 or three capacitors 61 can be moved to the additional circuit board 6, so as to adjust or increase the capacitors 61 on the branch loops. Consequently, through the arrangement of the three-dimensional interlayer, the horizontal outlet direction of the windings 22 can be changed to the vertical and up-down outlet direction, so that the overall volume of the EMI filter system 5 is reduced, and the space utilization of the circuit board 3 and the additional circuit board 6 is enhanced.

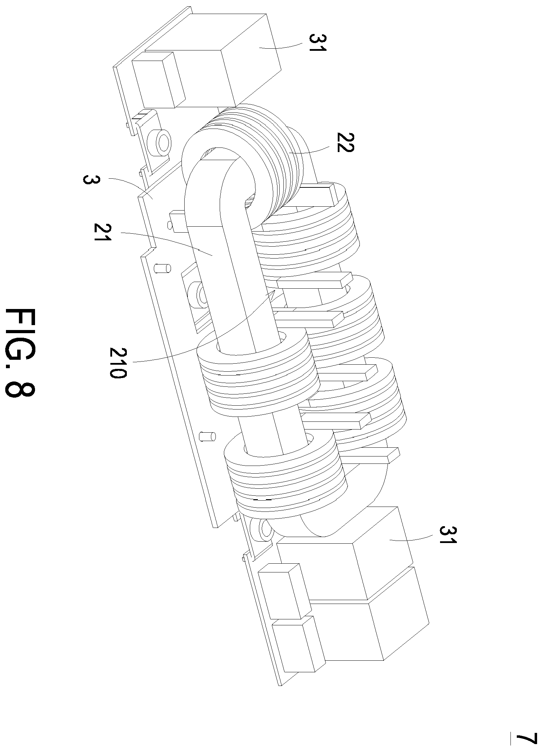

Please refer to FIG. 8. FIG. 8 is a schematic stereo view showing the EMI filter system according to a seventh embodiment of the present invention. The structures of the choke 2 and the circuit board 3 of the EMI filter system 7 of this embodiment are similar to above embodiments, that is, the circuit board 3 includes at least three capacitors 31, the choke 2 is mounted on the circuit board 3 and includes a non-circular magnetic core 21 and at least three windings 22, wherein the at least three windings 22 are wound on the non-circular magnetic core 21 and spaced apart with each other, and a portion of each winding 22 passes through the hollow portion 210 and is wound on the non-circular magnetic core 21. While in the embodiment, the number of the at least three capacitors 31 is three, and one of the three capacitors 31 is disposed on one side of the choke 2, and the other two the three capacitors 31 are disposed on another side of the choke 2. In other words, the three capacitors 31 are correspondingly disposed on the two opposite sides of the choke 2, so as to sandwich the choke 2 between the three capacitors 31, and to correspondingly connect to the second outlet end 22b of the at least three windings 22. Consequently, the number and the positions of the at least three capacitors 31 are not limited to the above embodiment, which can be changed according to the size of the circuit board 3 and the practical requirements. However, the arrangement requires the at least three capacitors 31 to be disposed adjacent to the choke 2, so as to achieve the efficiency of suppressing electromagnetic interference.

From the above descriptions, the present invention provides an EMI filter system, which includes a non-circular magnetic core and at least three windings, wherein the at least three windings are wound on the non-circular magnetic core and spaced apart with each other, and are connected to at least three capacitors mounted on the circuit board. Since the inner diameter of the non-circular magnetic core is relatively large, the distance between the at least three windings can be pulled further apart, the safety distance between the windings is sufficient and the layout problem of the conventional printed circuit board is also solved. Moreover, by arranging the at least three windings in series, the inductance can be greatly increased, or by arranging the at least three windings in parallel, the current can be shunted to reduce loss. Consequently, through the shape of the non-circular magnetic core of the choke and the winding position of the at least three windings and their arrangement in series or parallel, the number and position of the capacitors disposed on the circuit board can be flexibly adjusted. Consequently, the EMI filter system can achieve the efficacy of increasing the space utilization rate of the circuit board, suppressing the electromagnetic interference, reducing the overall device volume, increasing inductance, or performing current shunting and reducing loss.

## Claims

1. An EMI filter system (4), **characterized by** comprising:
a circuit board (3) comprising at least three capacitors (31); and
a choke (2) mounting on the circuit board (3) and comprising:
a non-circular magnetic core (21); and
at least three windings (22) wound on the non-circular magnetic core (21),
wherein the at least three capacitors (31) are disposed adjacent to the choke (2), and first outlet ends (22a) of the at least three windings (22) are respectively connected to the corresponding at least three capacitors (31).

2. The EMI filter system (4) according to claim 1, wherein the non-circular magnetic core (21) further comprises a hollow portion (210), when the at least three windings (22) are wound on the non-circular magnetic core (21), a portion of each winding (22) passes through the hollow portion (210) and is wound on the non-circular magnetic core (21).

3. The EMI filter system (4) according to claim 1, wherein the non-circular magnetic core (21) is an oval ring-shape magnetic core.

4. The EMI filter system (4) according to claim 1, wherein the non-circular magnetic core (21) comprises an oval ring-shape main body (215) and a U-shape extension part (216).

5. The EMI filter system (4) according to claim 1, wherein when the choke (2) is mounted on the circuit board (3), the at least three capacitors (31) are disposed on a same side of the choke (2).

6. The EMI filter system (4) according to claim 1, wherein when the choke (2) is mounted on the circuit board (3), the at least three capacitors (31) are disposed on two opposite sides of the choke (2).

7. The EMI filter system (4) according to claim 1, wherein the at least three windings (22) are arranged in series, in parallel, or in series and parallel.

8. The EMI filter system (4) according to claim 1, wherein the EMI filter system (4) further comprises an additional circuit board (6), and the additional circuit board (6) comprises at least one capacitor (61) for corresponding connecting to at least one second outlet end (22b) of the at least three windings (22).

9. An EMI filter system (4), **characterized by** comprising:
a circuit board (3) comprising at least three capacitors (31);
an additional circuit board (6) comprising at least one capacitor (61); and
a choke (2) sandwiched between the circuit board (3) and the additional circuit board (6), and comprising:
a non-circular magnetic core (21); and
at least three windings (22) wound on the non-circular magnetic core (21),
wherein the at least three capacitors (31) of the circuit board (3) and the at least one capacitor (61) of the additional circuit board (6) are disposed adjacent to the choke (2), and first outlet ends (22a) of the at least three windings (22) are respectively connected to the corresponding at least three capacitors (31) of the circuit board (3), and at least one second outlet end (22b) of the at least three windings (22) is connected to the at least one capacitor (61) of the additional circuit board (6).

10. The EMI filter system (4) according to claim 9, wherein when the choke (2) is sandwiched between the circuit board (3) and the additional circuit board (6), a first side faces the circuit board (3), and a second side faces the additional circuit board (6).
